(19) Europäisches Patentamt
European Patent Office
Office européen des brevets

(11) **EP 2 298 051 B1**

(12) **EUROPEAN PATENT SPECIFICATION**

(45) Date of publication and mention
of the grant of the patent:
**01.02.2012 Bulletin 2012/05**

(51) Int Cl.:
***H05K 7/20*** (2006.01)

(21) Application number: **09750088.8**

(22) Date of filing: **20.05.2009**

(86) International application number:
**PCT/GB2009/001271**

(87) International publication number:
**WO 2009/141610 (26.11.2009 Gazette 2009/48)**

(54) **RACK MOUNTED COOLING UNIT**

KÜHLEINHEIT MIT RACKANBRINGUNG

UNITÉ DE REFROIDISSEMENT MONTÉE DANS UNE BAIE

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(30) Priority: **20.05.2008 GB 0809188**
**06.03.2009 GB 0903938**

(43) Date of publication of application:
**23.03.2011 Bulletin 2011/12**

(73) Proprietor: **Semper Holdings Limited**
**London EC1V 0DS (GB)**

(72) Inventor: **BROUILLARD, Thomas, Wayne**
**Northamptonshire NN14 1HB (GB)**

(74) Representative: **Hall, Matthew Benjamin**
**Dehns**
**St. Bride's House**
**10 Salisbury Square**
**London EC4Y 8JD (GB)**

(56) References cited:
**US-A1- 2001 042 616     US-A1- 2005 133 214
US-A1- 2006 139 877     US-A1- 2006 232 945
US-A1- 2008 160 902     US-B1- 7 372 698**

**EP 2 298 051 B1**

**Description**

This invention relates to a cooling unit suitable for mounting in any standard IT enclosure. Such enclosures or racks are commonly used in computer server rooms (also known as data centres) to hold a plurality of servers in a space efficient yet accessible manner. In particular therefore this invention relates to the use of such a cooling unit within a data centre or computer room.

Over the past two decades computers have played an increasingly important role within society, in both the public and private sectors. The world economy is shifting from paper-based to digital management. Datacentres are found now in nearly every sector; Medical, Education, Communication, Enterprise, Finance, and Transportation. Most businesses would be severely handicapped without some form of computerised customer relations management.

In government and business environments the assured high availability of IT is considered to be business critical. Office workers now use computers with increasing frequency during the course of their daily operations. In addition the Sarbanes-Oxley legislation, also known as SOX, has had a huge impact on data storage and retrieval systems. As a consequence, companies rely very heavily on computer hardware and software to store company records, as well as to provide word processing and other administrative applications. Further, as the internet becomes an ever more important commercial tool, it is beneficial for companies to provide continuous internet access to their employees as well as maintain internet websites for client and customer use. Thus, the value of the uptime is worth many times more than the cost of the network.

Due to the commercial importance of a company's computer resources, it is standard practice for companies to operate a client-server IT system. In such systems a company's computers do not operate independently but instead all information is stored within main, centralised servers; to which computer terminals are connected. This allows employees to access the same company data from a wide range of terminals while allowing the servers to be located in a single area for ease of maintenance and security. In addition, as a company's data storage and processing requirements increase, additional servers or software applications can be added to the server bank with minimum disruption to the users.

The room or area containing these servers is often referred to as a "data centre". Depending on the size of the company in question, the data centre can occupy one room or floor of a building, or in some instances an entire building may be given over to the housing of computer servers.

Servers and other electronic components of the data centre are housed in racks. These maximise the use of space within the data centre. While, over the years developments have resulted in great changes in computer technology, rack design has remained constant.

Racks conforming to the EIA (Electronic Industries Association) 310 D standard are the most common form of rack used to house a plurality of computer servers. Such racks generally comprise four vertical rails, or mounting flanges, with two pairs of opposing rails defining a rectangular enclosure. The use of just two opposing vertical rails is also known.

Each vertical rail has along its length a number of holes spaced at regular intervals, the holes in each rail being aligned so that each hole is part of a horizontal pair. The holes do not need to be evenly spaced down the length of the rail but instead must conform to one of several configurations specified in the EIA 310 D standard.

The most common configuration is referred to as "universal spacing". In this layout the centre of the first hole must be spaced from the end of rail by a minimum of 6.75mm (0.266"). The centre to centre distance between the first three holes is 15.90mm (0.626") while the distance to every forth hole is only 12.7mm (0.5"). This results in three holes being provided for every 44.45 mm (1.75"). This length is referred to as a unit (U). "Wide spacing" layout is identical to universal spacing except that the middle of the three holes spaced at 15.9mm is removed. This results in alternate spacings between holes of 31.8mm (1.252") and 12.7mm (0.5").

The EIA 310 D standard also covers hole spacing in compliance with IEC 25 mm practice. In such configurations the holes are spaced at 25mm intervals with the end holes being positioned at least 12.5mm from the ends of the rails.

The use of standardised hole spacing allows various components, for example subracks, panels, servers etc, to be attached to the rack through provision of mounting brackets having an equivalent hole spacing. This enables the equipment to be fastened to the rack by aligning the holes of the mounting brackets with the holes of the rail and passing fastening means, such as nuts and bolts, through the aligned holes.

It is also common for servers to be mounted on sliding rails such that the servers can be easily removed from the rack for maintenance. In such cases a slideable shelf or slide rails are mounted to the rack and the sever is fastened to this. Usually the server is still secured to the rail directly in order to lock this in place until the server needs to be removed from the rack. The mounting brackets can be released from the rail when desired to allow this.

As well as providing standardised hole spacing, the EIA 310 D standard also places restrictions on the width between the opposing rails. Three width measurements are provided; the useable aperture between the rails ($W_2$), the panel opening.width (the total width inclusive of the rails) ($W_1$) and the centre-to-centre distance between mounting holes on opposing rails ($W_3$).

The widths specified in the superseded EIA 310 C specification are included in the EIA 310 D specification. Three width configurations are specified, in which:

$W_1$ = 483.4mm (19.031") min
$W_2$ = 450mm (17.717")
$W_3$ = 465mm (18.307") $\pm$1.6

$W_1$ = 610.4mm (24.031 ") min
min $W_2$ = 577mm (22.717") min
$W_3$ =592mm (23.307") $\pm$1.6

$W_1$ = 763mm (30.039") min
$W_2$ = 730mm (28.74") min
$W_3$ =745mm (29.331") $\pm$1.6

The first of these configurations is most commonly used in-the industry and is referred to as a 19" rack, in reference to its panel opening width ($W_1$).

The EIA 310 D standard also includes an additional width configuration which complies with the IEC 25mm practice. In accordance with this configuration

$$W_1 = (W_X + 35) \pm 2$$

$$W_2 \geq W_X$$

$$W_3 = (W_X - 15) \pm 2$$

where $W_x$ is a control dimension and all measurements are in mm. The preferred control dimension is 450mm, which results in the same width measurements as the 19" rack. However, the standard allows the control dimension to be increased in increments of 25mm.

Height dimensions are also specified by the EIA 310 D standard. However, these are more flexible in that the height can be any increment of U, in respect of the EIA 310 C configurations, or SU (Standard Unit = 25min), in respect of the IEC 25mm configuration, plus a given constant to provide clearance. Typically a rack will be 42U in height and have a depth of between 800 and 1200mm.

The above dimensions refer only to the metal rails (mounting flanges) of the rack to which electrical components will be attached. These rails are held in place by an external framework which can be panelled to form a housing or cabinet, however this is not essential. The external framework and panelling can be distanced from the rails in order to provide spacing within the cabinet for cabling, pull handles etc. The EIA 310 D specification provides guidelines for the outside dimensions of cabinets but these are optional. Full details of the EIA 310 D standard are available from IHS (Information Handling Services Inc.).

The use of standardised EIA 310 D racks allows a business to store a plurality of servers within a single rack or within a plurality of adjacent racks and to adjust their layout as desired.

The grouping together of large numbers of computer servers results in the generation of a large amount of heat. In order to prevent the server microprocessors from overheating and failing, it is imperative that air entering the server be maintained at sufficiently cool temperatures. In 2004 ASHRAE (American Society of Heating Refrigeration and Air conditioning Engineers) specified recommended guidelines, established in conjunction with computer manufactures, for maximum and minimum temperature and humidity levels. These were published in Thermal Guidelines for Data Processing Environments, TC 9.9. Temperatures of 20 to 25°C and a relative humidity of 40 to 55% are recommended.

Originally, air conditioning in data centres was provided by cooling units located along the perimeter walls of the computer room. These units would draw in room air at a mixed temperature from the data centre, cool the air, and discharge the cold air into a floor void plenum created by raised flooring. This cold air, under pressure in the floor void, is free to circulate below the floor and to re-enter the room through perforated floor tiles or grilles in the raised floor to cool the data centre. Most data centres still operate this type of "raised floor" cooling system.

As described in the above mentioned ASHRAE recommendations, modern data centres containing several rows of server racks should be arranged to provide "hot" and "cold" aisles. That is, the servers in one row are all positioned such that the hot air emitted from the servers is directed into the same aisle. The servers on the opposing side of this aisle are arranged to direct heat into the same aisle. This creates a central "hot" aisle between the rows, with two "cold" aisles on the outer sides of the rows This allows the maximum separation of hot and cold air within the rows of racks which in turn provides the best possibility for thermal management by avoiding, in so far as possible, the mixing of hot and cold air streams within the datacentre.

However, systems which rely on cooling units that are located along the perimeter walls of the room do not operate at maximum cooling capacity due to the mixing of hot and cold air being drawn into the return of the cooling units and the unpredictability of the air flow within the floor void plenum. Underfloor power and data cabling cause obstruction to air flow and exacerbate the problem of proper air distribution. This is particularly noticeable if one air conditioning unit fails. Although such under floor cooling systems are suitable for centres in which less than approximately 4 kW per rack of heat is produced, with ever increasing load density caused by compaction and deployment of blade servers, many data centres now struggle to provide adequate cooling.

It is now recognised that traditional power and cooling system designs no longer provide a viable solution for the high density IT loads experienced in today's data centres. Advances in computer technology have resulted in rooms which were designed for an average of 2 kW per rack now seeing racks of servers producing 20 to 30 kW of heat. The problem of more heat is exacerbated by higher discharge temperatures, which have nearly doubled with the advent of blade servers. As increasingly large investments are being made for smaller and smaller percentage improvements in efficiency and reliability, power and cooling issues will prevent investments in IT infrastructure.

In addition, server loads are now becoming dynamic as "sleep mode"s are incorporated when idle. This results in an instantaneous step change in heat output which can be as great as from 3 to 24 kilowatts in a single rack. Cooling units located along the perimeter walls and raised floor cooling cannot respond to such dynamic changes.

Further, the proliferation of IT usage contributes greatly to the issue of global warming, with a larger carbon footprint than the airline industry. Therefore more efficient methods of heat removal must be developed.

Consequently; in recent years there has been a move towards providing "close coupled cooling". Close coupled cooling does not rely on under floor air distribution to attempt to deliver cold air in the correct amount to the right place within the required response time. Instead, close coupled cooling is a design methodology that effectively removes heat at its source.

This is achieved by placing cooling units amongst the racks of servers such that the cooling coils of the cooling units are positioned very close to the heat source.

Close coupled cooling represents a move away from the traditional approach of attempting to maintain the entire data centre at a uniform, cool temperature and towards the neutralisation of heat within the hot aisle, thus not allowing the exhaust heat from the IT servers to enter the room and recirculate to the front of the rack where it could enter the IT servers at too high a temperature. Providing cooling units within the server rows enables the hot aisle to be enclosed to prevent heat from dissipating throughout the data centre. By providing cooling units amongst the server racks, these can remove hot air from the hot aisle and supply air just below room temperature back into the cold aisle. In this way the heat generated within the data centre is neutralised without circulating throughout the room.

There are many inherent benefits of close coupled cooling. By increasing the return air temperature to the cooling units from a mixed room air temperature of 24°C to a hot aisle temperature of 34°C, an increase in cooling coil capacity of more than 40% can be achieved with no increase in initial first cost or unit quantity and eliminating the unpredictability of cold air distribution inherent in the use of a raised floor system.

Several companies presently supply cooling units for use amongst conventional server racks. For example American Power Conversion Corp. currently market an "In Row RC and RP" chilled water cooler. This is a computer room air conditioning system designed for installation amongst a row of server racks. This product is an integrated stand alone unit which can be positioned as desired by the data centre manager. Equivalent stand alone units are also provided by a number of other manufacturers, such as Rittal and Knuerr. A further example of cooling units being installed amongst a row of server racks can be seen in US-A-2006/139877.

However, these stand alone cooling units must be placed within existing rows, causing disruption to the data centre during retro-fit, including electrical wiring and chilled water piping. In addition, the cost of these components is high and location must be determined at time of rack layout, thus reducing room flexibility.

Therefore, a business looking to modify its data centre in light of recent changes in cooling methodology faces a high cost, both financially and in terms of disruption to existing units within the data centre.

Consequently, there exists a need within the industry to provide a more cost-effective cooling unit which can utilise existing assets and can be easily integrated into a data centre.

In accordance with the present invention there is provided a rack as described in claim 1.

The invention includes a self contained cooling unit which can be easily inserted and fixed within existing IT server racks. As discussed above, rack design has remained fairly constant over the years such so that old and new servers can be housed within the same rack. This consistency allows server designers to create servers having dimensions which will enable their use alongside existing servers in existing racks.

Rather than provide a separate stand alone cooling unit the inventors of the present invention have taken advantage of the standard rack dimensions to provide a cooling unit that can be simply and quickly inserted into any server rack.

Preferably the housing comprises mounting brackets for attachment to said rack.

As discussed above, nearly all racks within data centres conform to EIA 310 D standards and in particular to the 19" or 450mm configuration. Therefore, preferably the housing is sized to fit within an IT server rack conforming to EIA 310 D specifications.

The mounting brackets of the cooling unit housing are designed to match the EIA 310 D standard and hence to provide a secure fixing of the unit to the rack. These brackets can be integrally formed on the housing or be produced separately and fixedly secured to the housing

Preferably the mounting brackets each comprise a series of holes conforming to either universal spacing or IEC 25mm requirements, In this way the cooling unit can be made for attachment to racks having any of the hole layouts prescribed by the EIA 310 D standard. It is possible for both types of mounting brackets to be provided on the housing so that either can be used to fasten the unit to the rack to as required.

In another preferred embodiment the mounting brackets comprise a first portion having holes spaced in accordance with universal spacing layout and a second portion having holes spaced in accordance with 25mm requirements. In this way the same mounting bracket can be used to attach the cooling unit to either universal or wide spacing rails (by aligning the holes of the first portion with the holes of the rails) or 25mm rails (by aligning the holes of the second portion with the holes of the rails).

Instead of universal spacing, the hole layout of the bracket, or first portion of the bracket, can conform to wide spacing layout.

The mounting bracket may comprise an L-shaped rail that is mounted horizontally to - the inside of the rack. Slots at each end provide holes for bolts to pass through to attach the cooling unit to the vertical U rails of the rack and to allow for some flexibility in positioning. Preferably four vertical slots are provided, two at each end and arranged one above the other.

The housing may also include flanges, through which bolts or other type of fastener may pass into a vertical U rail of the rack to secure the unit in place. In a most preferred embodiment a flange is provided on a rear edge of a preferably removable grille panel. The flange may project outwardly and extend vertically up the side of the housing when the grille panel is in place: In this way the cooling unit can be pulled forward in the rack so that the flange abuts against the vertical U rail of the rack and the at least one cooling fan projects beyond the rack boundary.

By providing a self contained cooling unit having dimensions suitable for insertion into a rack conforming to EIA 310 D standards, the inventors of the present invention have created a simple means of including a cooling unit within a row of servers. As no stand alone cooling unit must be bought the cost is greatly reduced. Furthermore, the cooling unit can be easily mounted to an existing EIA 310 D rack at any desirable position within the data centre.

This enables smaller businesses to take advantage of the latest developments in computer room cooling technology.

Should a cooling unit fail, the position of other cooling units in a close coupling arrangement within a server rack alongside the equipment that needs to be cooled, means that there is less build up of regions of hot air as a result of the redundancy than with a conventional arrangement where cooling units are arranged around the perimeter of a room. Mounting the cooling units within a server rack therefore optimises the close coupling benefits, making it much easier to build in reliable redundancy into the system at row level. The close coupling also minimises local fluctuations in temperature, which is particularly important for high density arrangements.

Preferably redundancy is built into the cooling arrangements, for example, N+1 or N+2 cooling units may be provided within the server rack or racks for a cooling demand requiring N cooling units without spare capacity. Running all of the cooling units at lower speeds to achieve the same airflow in a cooling system where redundancy is built-in offers running cost advantages over comparable cooling systems having no redundancy where the fans are operating at higher speeds. For example, running six fans at a lower speed to achieve a nominal air volume flow of 16,000 $m^3$/h with +2 redundancy (i.e., an N+2 configuration where N=4) can result in a 33% reduction in annual running costs compared to running four fans at higher speeds to achieve the same airflow with no redundancy. Thus building in redundancy can result in lower power consumption and produce significant operating cost advantages, while at the same time offering increased operational flexibility. Against the benefits, there is a slight downside of the higher initial installation costs and operational maintenance costs of the additional units.

Arranging the cooling units within a sever rack means that they can be arranged in an enclosed hot aisle format with the associated benefits in efficiency and the avoidance of changes to room temperature.

As mentioned above, although the EIA 310 D standard covers a number of alternative widths, the most commonly used configuration is that having an internal width ($W_2$) of 450mm. Such a rack is commonly referred to as a 19" rack. In order to fit within this common type of rack the cooling unit housing must have a width of less than 450 millimetres. In addition, although the height and depth of 19" racks are not specified, it is preferable that a cooling unit designed for use with such a rack has a depth of no more than 1,000 mm and a height of less than 1866 mm (42U). However, in relation to depth, as not all server racks form enclosed cabinets this dimension of the cooling unit housing is not essential. As long as the cooling unit can be slid into and attached to a standard IT rack this will meet the requirements of the invention.

A preferred cooling unit comprises at least one cooling coil, at least one fan for circulating air through said at least one cooling coil and a housing containing said at least one cooling coil and fan, wherein said housing has a width of less than 450 mm, a depth of no more than 1,000 mm and a height of less than 1866 mm. In one preferred arrangement, four fans for circulating air through at least one cooling coil are arranged in a stack configuration for fitting within this height. The four fans may be arranged as two units of two fans, to facilitate handling, with each double fan unit having its own cooling coil.

In practice the height dimension of the cooling unit housing will be much less than this upper limit. This allows a cooling unit to be inserted into the same rack as other components, such as servers.

Preferably the cooling unit housing has a width of approximately 448 millimetres. A preferred measurement for the depth is 895 millimetres and a preferred dimension for the height is 890 millimetres.

Alternatively, the cooling unit can be sized to fit within a 24" EIA 310 D rack. In such racks the internal width ($W_2$) is 577mm and therefore the housing must have a width less than this.

The mounting brackets can be arranged to provide direct or indirect attachment to the rack. By direct mounting it is meant that the mounting brackets are connected directly to the vertical rails of a standard IT rack. Indirect mounting means that the cooling unit is instead mounted to, for example, sliding rails or a shelf located within the rack. This is beneficial as it allows the cooling unit to be easily slid out of the rack for maintenance.

Therefore, preferably the mounting brackets are arranged to provide indirect attachment to said rack. The housing can be provided with mounting brackets at the front and rear of the housing, preferably both, so that the cooling unit can be fastened to both the front and rear rails of the rack.

The cooling unit may be a chilled water cooling unit. That is, in use the cooling coil is attached to a chilled water supply. However, it is also possible for the cooling unit to operate using another type of coolant or a refrigerant

Preferably the cooling unit further comprises a filter. This prevents the inner components of the cooling unit from becoming clogged with dust and other particulate matter.

The cooling unit can be provided separately, for insertion into any existing standard rack, in particular an EIA 310 D rack. However, it is also possible for the cooling unit to be supplied already mounted within such a rack.

Therefore, unlike integrated, stand alone cooling units, the rack of the present invention contains an entirely removable cooling unit. The rack and cooling unit are separate components which can each be used independently of the other. This allows the flexibility to upgrade the cooling capacity of a given computer root as new higher performance IT equipment is added, i.e. cooling units can be added to or removed from racks and repositioned.

In a preferred embodiment the cooling unit comprises a housing sized to fit within a rack conforming to EIA 310 D. standards and is adapted for attachment to said rack.

In one preferred embodiment, the rack comprises a first pair of opposing vertical rails and a second pair of opposing vertical rails, the first and second pairs of rails being spaced apart from each other so as to define an interior space, said interior space having a width of approximately 450mm, wherein the opposing rails of said first and second pair of vertical rails are in an opposing relationship across the width of the interior space, each rail containing a series of holes along its length, said series of holes of one rail being horizontally aligned with said series of holes of the opposing rail such that the centre to centre distance between opposing holes is approximately 465mm, the cooling unit having dimensions less than that of the interior space such that the cooling unit can be inserted into this space and comprising mounting brackets for attachment to said opposing vertical rails via said series of holes.

In another preferred embodiment the interior space has a width of approximately 577mm and the centre to centre distance between opposing holes is approximately 592mm.

A rack in accordance with the present invention, hereafter referred to as a cooling rack, can be positioned beside racks containing multiple servers in order to provide close coupled cooling, as discussed above. In addition it is also possible for servers to be mounted within the cooling rack itself.

In order to ensure that heat from surrounding servers is most efficiently collected by the cooling unit, the rack preferably comprises a return air plenum attached to the cooling unit, said plenum being extendible so as to enclose the rear of at least one rack conforming to EIA 310 D specifications.

This plenum is therefore capable of enclosing one or more EIA 310 D racks and can direct hot air emitted from these racks to the cooling unit. This prevents dispersal of hot air throughout the data centre. This plenum may comprise the unused space at the rear of the cooling rack in embodiments in which the rack has a depth greater than the cooling unit. In a preferred embodiment the plenum further comprises a liner or panel positioned at the rear of the cooling rack and additional liners or panels similarly positioned on one or more adjacent server racks. This creates a sealed plenum directing emitted hot air to the cooling unit.

The use of cooling units and cooling racks according to the present invention enables the user to benefit from all the advantages associated with close coupled cooling without the need for specialised cooling units to be incorporated into the data centre layout.

Additionally, it has been discovered that, if the fan of the cooling unit is positioned outside the rack boundary, the electrical power consumption of the fan motors is greatly reduced. This is accompanied by a reduction in the carbon footprint of the cooling unit. This is because there is no internal static pressure loss for the fan to overcome as is exhibited by fans that are wholly enclosed inside a cabinet. Use in this configuration also allows a cooled air stream to be supplied directly across the front of the adjacent racks housing the IT servers.

Therefore preferably the cooling unit of the present invention is mounted to the rack such that the at least one fan is located outside the rack boundary. By "rack boundary" it is meant the external dimensions of the rack, including any panelling attached to the framework of the rack. The fan can be mounted in this position by removing any front door or panelling from the rack in which the cooling unit is to be installed and then mounting the unit such that the fan protrudes from the rack boundary. Alternatively a panel or bracket can be provided which comprises an aperture through which the fan can extend.

The cooling unit can be positioned such that the fan protrudes from the rack boundary by altering the location of the mounting brackets on the housing or adjusting the position at which the cooling unit is attached to a shelf within the rack. Alternatively the cooling unit , can be inserted into a rack having a depth less than that of the cooling unit housing such that the fan extends out of the rack boundary.

Preferably the cooling unit having the at least one fan includes a bracket which has two or more intended mounting positions to allow the cooling unit to be mounted both for use in a recessed configuration, i.e., with the at least one fan located within the rack boundary, and optionally for use in a semi-recessed configuration, i.e., with the at least one fan located outside the rack boundary. This provides all the previously mentioned advantages of the close coupled cooling for the high density IT loads in the recessed configuration, but it also allows the designer to take advantage of the efficiency savings and other benefits where the cooling unit can be pulled forward, so that the at least one fan is located outside the rack boundary. The bracket may allow the cooling unit to be slid between the recessed and semi-recessed configurations, as desired.

In the semi-recessed configuration, a fan operating at a reduced power can provide the same air flow volume as a fan in the fully-recessed configuration operating at a higher power. A reduction in fan power of 10% or more is possible, e.g. 15% or more, and in some instances 20% or more.

Operating the fan at lower power will also result in much lower operating noise. In one example recorded sound pressures of less than 70dB(A) at 2m were achieved. Pulling the cooling unit forward in the rack so that at least one fan is located outside the rack boundary also means that the rear of the cooling unit is pulled forward too. This creates a larger void at the rear of the rack to form the plenum for directing hot air into the cooling unit. In some arrangements this can lead to further improvements in efficiency.

In the discussion herein of "recessed" and "semi-recessed configuration", and the location of the fans "within" or "outside" the rack boundary, is intended to be interpreted purposively. In other words, it is the actual air moving part of the fan (e.g., the vanes) that should be mounted so as to project outside of the rack boundary in the semi-recessed configuration. The fans draw in air in an axial direction and eject it in a substantially radial or sideways direction. Noticeable benefits in efficiency will be obtained when a substantial amount of the fan is mounted outside of the rack boundary, for example, when 75% of the fan is projecting beyond the rack boundary, more preferably 90%, and yet more preferably 95% or more, and accordingly these are envisaged within the definition of the semi-recessed configuration. Most preferably 100% of the fan (excluding mounting or drive components etc.) will be located outside of the rack boundary in the semi-recessed configuration, as this will produce the optimum savings in energy consumption.

In embodiments in which the cooling unit comprises a plurality of fans it is preferable for each fan to protrude from the rack boundary.

Preferably a controller unit for the at least one fan, and more preferably for four fans arranged in two cooling units, is a separate component from the cooling units and is arranged in a 2U,draw out enclosure. By separating the controller unit from the cooling units, it allows the cooling coil to be made larger (for example a full 20U in height) which in turn results in better cooling of the hot air. Also using a single controller unit to control the four fans of the two cooling units, reduces the number of components that need to be manufactured and powered.

In order to maximise the cooling effect of the cooling coil, preferably the cooling unit is provided in a housing which is shaped as a rectangular prism, wherein a front region of the housing is provided with at least one fan, and a rear region for the housing, defining a smaller rectangular prism, is provided with at least one cooling coil, the cooling coil comprising a planar matrix which is arranged diagonally within the smaller rectangular prism, extending from a corner edge adjacent the front region to a rear corner edge of the housing. In one embodiment, the housing encloses two fans in the front region, one arranged above the other, and one upright cooling coil matrix extending diagonally across the rear region of the housing. In another the housing encloses four fans in the front region, one arranged above the next in a stack four high, and one upright cooling coil matrix extending diagonally across the rear region of the housing.

The housing incorporates a grille for the area surrounding the front region of the housing that contains the at least one fan. A grille is provided on both sides of the front region of the housing, and in one embodiment the grille panel is removable. When the cooling unit is mounted in a semi-recessed configuration, with the at least one fan located outside the rack boundary (i.e. the cooling unit is mounted so that a majority or all of the front region of the housing protrudes beyond the rack boundary), the grilles allow the cool air to be directed across the fronts of the adjacent IT racks, unimpaired. If desired, covers for the side grilles, or replacement closed panels, may be provided for when the cooling unit is mounted in a recessed configuration and the fan is located back within the rack boundary.

In one embodiment, the present invention includes a rack mountable cooling unit comprising at least one cooling coil, one or more cooling fans for drawing air through the at least one cooling coil, more preferably two or four cooling fans arranged in a stack, and a housing containing said at least one cooling coil and fan or fans, wherein the housing comprises a front region which houses the fans, and a rear region which houses the at least one cooling coil, and wherein the front region comprises at least one grille to allow air from the fans to escape sideways from the housing with little or substantially no obstruction. In one embodiment, the rear edge of the grille panel incorporates a flange for locating against the vertical U rail of the rack. The grille can be of any form, for example, a wire grille, a panel with holes, a criss-cross array of strips, a louvered panel, etc, indeed any form of grille which prevents harm to workers but allows as much air as possible to flow out from the sides of the housing. In some embodiments, where safety regulations allow, it may be possible to have just open sides and no grille present. By contrast, the portion of the sides of the housing corresponding to the rear region enclosing the at least one cooling coil may be fully enclosed.

In addition to cooling facilities, many other components are required to ensure smooth operation of data centres. For example, power distribution units are used to reduce the incoming multiphase supply electrical power to multiple single phase supplies for the IT equipment an associated components. Typically power distribution is achieved in data centres through use of slim-line racks or stand alone units.

However, in a preferred embodiment of the invention the cooling rack can further contain a self-contained, removable power distribution unit.

By including the power distribution unit in a standard rack the same benefits can be achieved as in respect of the cooling unit. Further, as both the cooling unit and power distribution unit are self-contained and removable, these can be replaced or subject to maintenance without affecting operation of the other unit.

In order to be contained within the cooling rack the power distribution unit (PDU) must have suitable dimensions and attachment means for insertion into an IT server rack. Preferably the PDU has suitable dimensions and mounting brackets for direct or indirect attachment to a rack conforming to EIA 310 D standards, most preferably a 19" or 24" rack.

Preferably the rack further comprises a self-contained, removable uninterruptible power supply (UPS) unit. Such units are commonly found within data centres in order to continue to supply the servers in the event of power failure.

In order to be contained within the cooling rack the uninterruptible power supply unit (UPS) must have suitable dimensions and attachment means for insertion into an IT server rack. Preferably the UPS has suitable dimensions and mounting brackets for direct or indirect attachment to a rack conforming to EIA 310 D standards, most preferably a 19" or 24" rack.

By providing all three components in a single rack the essential mechanical and electrical datacentre components can be grouped together for ease of maintenance and wiring.

The IT rack does not need to contain any servers in addition to these units, just be of the type designed to house such servers. Preferably the rack conforms to EIA 310 D specifications. In such embodiments the cooling unit, PDU and UPS therefore all comprise housings having dimensions suitable for insertion into a EIA 310 D rack and mounting brackets for attachment to said rack.

Unlike stand alone integrated units, the rack of the present invention enables a plurality of functions to be carried out from a single rack. Furthermore, each unit can be individually serviced and replaced as necessary. The units can be inserted into an existing rack within a computer room or data centre thus reducing cost.

As discussed above, the cooling unit (as well as the PDU and UPS) can be positioned within any standard EIA 310 rack as desired. Furthermore, the cooling rack containing this cooling unit can itself be located in a variety of positions within the data centre.

Preferably the cooling rack is positioned between two racks each containing a plurality of servers. The cooling unit within the cooling rack can then remove heat from the servers within these racks. Preferably a return air plenum is attached to the back of the cooling unit and encloses the rear of at least one of said racks. Any void inside the rear of the rack(s) may comprise part of the return air plenum.

In other preferred embodiments a plurality of cooling racks can be positioned within one or more rows of server racks, these rows preferably being configured so as to provide hot and cold aisles.

Preferred embodiments of the invention shall now be described, by way of example only, with reference to the accompanying drawings in which:

Fig. 1 shows an example of a standard EIA 310 D rack;
Fig. 2 shows a the dimensions specified in the EIA 310 D standard;
Figs. 3A-C show the different hole spacings provided in the EIA 310 D standard;
Fig. 4A shows a top view of a cooling unit for use in the present invention;
Fig. 4B shows a side view of a cooling unit for use in the present invention;
Fig. 4C shows a front view of a cooling unit for use in the present invention;
Fig. 5 shows a cooling rack in accordance with the present invention;
Fig. 6 shows a schematic view of a datacentre containing cooling racks according to the present invention;

Fig. 7 shows a schematic view of the cooling unit of Figs. 4A-C in an alternative embodiment of the cooling rack of the present invention;

Fig. 8 shows a perspective view from the rear of a preferred cooling unit;

Fig. 9 shows a perspective view from the side of the cooling unit in Fig. 8;

Fig. 10 shows a perspective view of the cooling unit in Fig. 8 with the housing panels attached;

Fig. 11 shows a preferred arrangement where two cooling units are provided, stacked on top of each other and operated by a separate controller unit;

Fig. 12 is a graph illustrating the airflow produced by the fans in a recessed and a semi-recessed configurations; and

Fig. 13 is a graph illustrating the fan power savings achievable with the cooling unit mounted in a semi-recessed position across the normal operating range of air volumes.

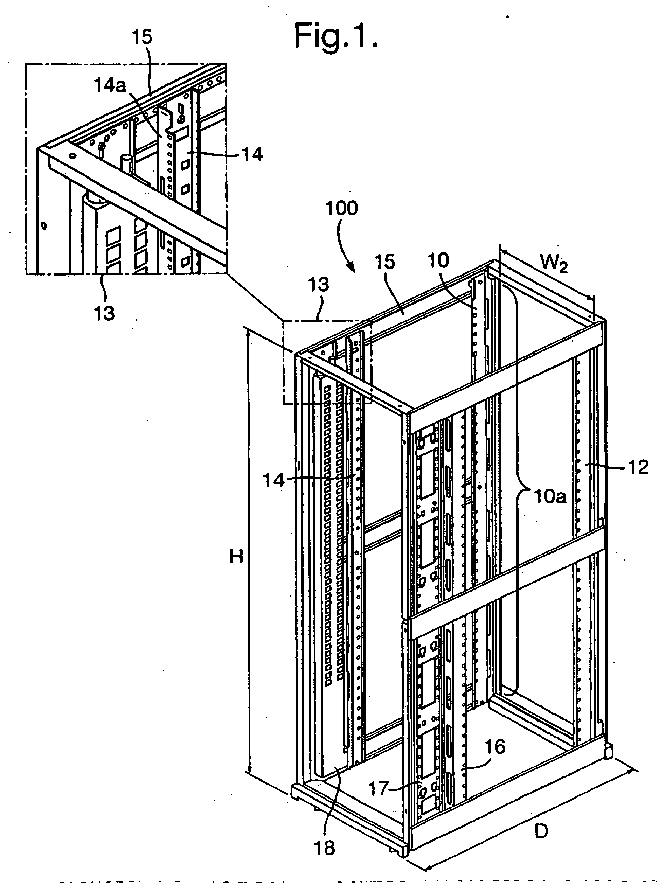

Fig. 1 shows a rack 100 conforming to EIA 310 D standards. Such racks 100 are used throughout the world to house a wide variety of servers including blade servers.

The rack 100 comprises four vertical rails 10, 12, 14, 16. These are fixed in relation to one another by frame 15. The front rails 10, 12 are separated from one another by a distance $W_2$, as are rear rails 14, 16. The front rails 10, 12 and rear rails 14, 16 can be separated from each other by various distances. Typically the total depth D of the rack is approximately 1,200 mm. The height H of the rack 100 can also vary, however most racks have a height of 42U. One unit, U, equals 44.45 mm (1.75"). Each rail 10, 12, 14, 16 comprises a series of mounting holes along its length. In Fig. 1 these holes can only be seem on rails 10 and 14 and are generally indicated in respect of rail 10 by numeral 10a. The series of mounting holes can be seen more clearly in the detail shown in boxed area 13. The mounting holes are located on arm 14a, which projects into the interior space of rack 100.

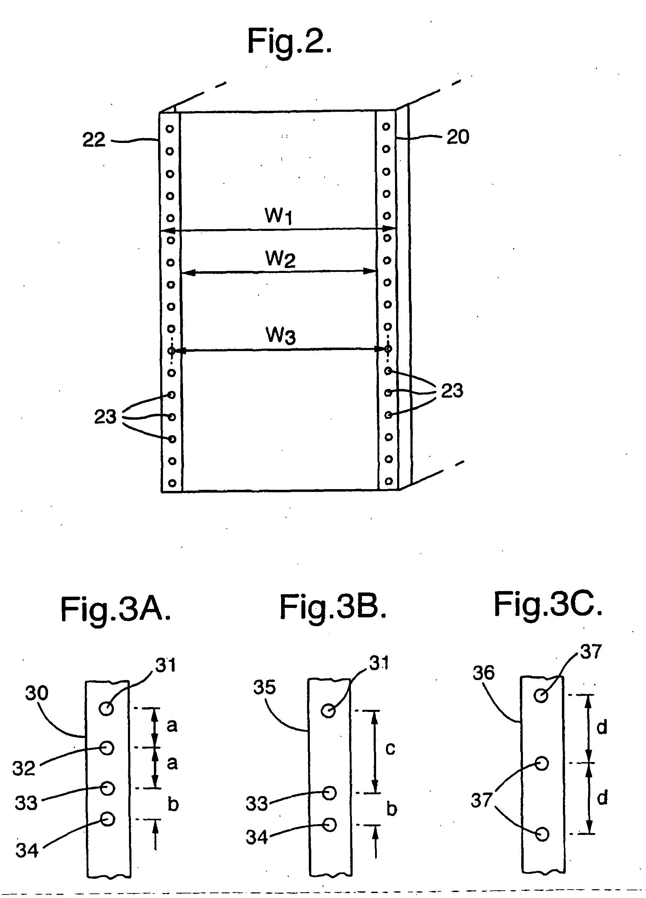

The standardised widths of an EIA 310 D rack 100 are shown in Fig. 2. This shows two rails 20, 22 in opposing relationship, each comprising a series of holes 23. $W_1$ is the total width, known as the panel opening, $W_2$ is the internal width, or usable aperture opening, and $W_3$ is the centre-to-centre distance between opposing holes 23, known as the panel mounting. The EIA 310 D specification provides various dimensions for these widths, the most widely used of which gives an internal width of 450mm. Racks having this width are commonly referred to as 19" racks. Other dimensions are possible, such as the 24" rack, as discussed earlier.

The rails 10, 12, 14, 16, 20, 22 all comprise a series of holes spaced along their length. The EIA 310 D specification provides three alternative hole layouts, shown in Figs. 3A-C.

Fig. 3A shows a rail 30 having universal spacing. Here the first three holes 31, 32, 33 are spaced from each other by a distance a of 15.9mm. The forth hole 34 is spaced from hole 33 by a distance b of 12.7mm. This layout is then repeated, such that the fifth hole is at a distance of 15.9mm from the forth hole etc. Fig. 3B shows a rail 35 having wide spacing.

This is identical to the universal spacing layout except that second hole 32 has been removed. This leaves a spacing c between holes 31 and 33 of 31.8mm while the distance b between holes 33 and 34 remains 12.7mm, Finally; the rail 36 shown in Fig. 3C conforms with IEC 25mm requirements. Therefore the spacing d between all holes 37 is 25mm.

Although shown as round, the holes could be square or oval shaped. All holes have a diameter approximately 7 mm.

The use of standard racks allows various manufacturers to provide servers in dimensions which will allow these to be used in the vast majority of data centres.

Returning to Fig. 1, panelling can be provided by attaching this to framework 15 in order to provide an enclosed space. This panelling can include a door panel to allow easy access to the interior of the enclosed space when desired. As well as vertical rails 10, 12, 14, 16 the framework 15 can also hold additional rails 17 for mounting of power distribution strips and related components 18. Rails 10, 12, 14, 16 can also contain structural features suitable for panel and door mounting etc.

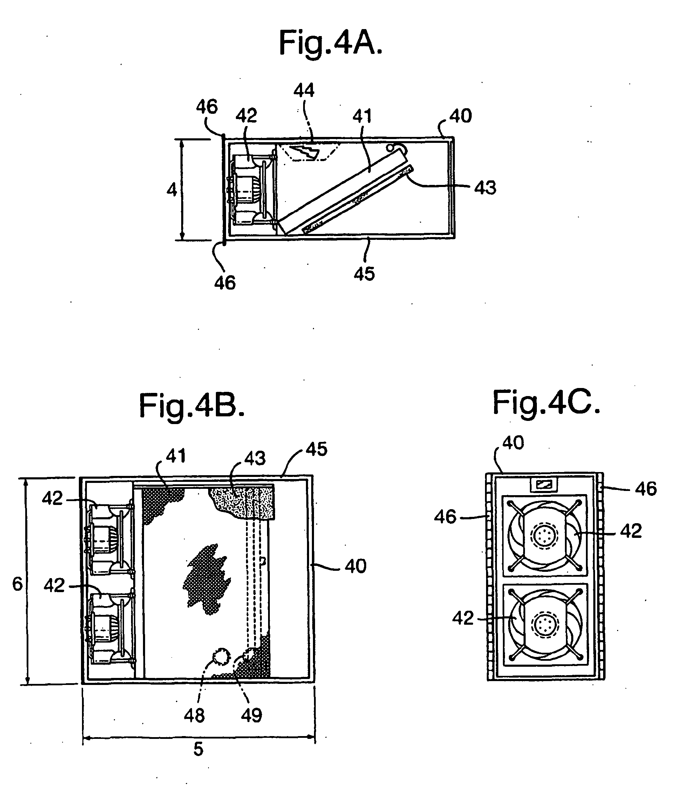

Figs. 4A-C show a cooling unit 40 for use in the present invention. As can be seen in Fig. 4A, cooling unit 40 comprises a cooling coil 41 and fan 42. A filter 43 is provided in front of the cooling coil in order to prevent dust from interfering in the workings of the cooling unit 40. The components of the cooling unit 40, including various sensors and alarms for ensuring correct performance, are controlled by control circuit 44, which is not discussed in detail herein. All the components of the cooler unit are contained within housing 45. Housing 45 encloses all components of the cooling unit 40, however air vents are provided at the front and rear of the housing 45 to allow air flow through the cooling unit 40.

As can be seen from Figs. 4B and C, cooling unit 40 comprises two fans 42. The number of fans will vary depending on the size of the cooling unit 40. Housing 45 contains input and output apertures 48, 49 for chilled water, which is fed through coil 41.

Housing 45 has a width 4 of 448 millimetres. The depth 5 of the housing 45 is 895 millimetres while the height 6 is 889 millimetres. The cooling unit 40 can therefore fit within a 19" EIA 310 rack 100, which has an internal width, $W_2$, of 450mm. Housing 45 is further provided with mounting brackets 46 which are positioned at the front of the cooling unit 40 and extend outward from the housing 45. These brackets 46 comprise a plurality of holes similar in size and spacing to those provided on the rails 10, 12, 14, 16 of rack 100. This enables the cooling unit 40 to be fastened onto rack 100.

Therefore, cooling unit 40 can be attached to any 19" EIA 310D rack to enable close coupled cooling to be achieved in existing or new data centres. Cooling unit 40 is sized such that two units 40 can be placed in a single rack 100, or alternatively additional electronic components can be mounted in a rack 100 together with a single cooling unit 40.

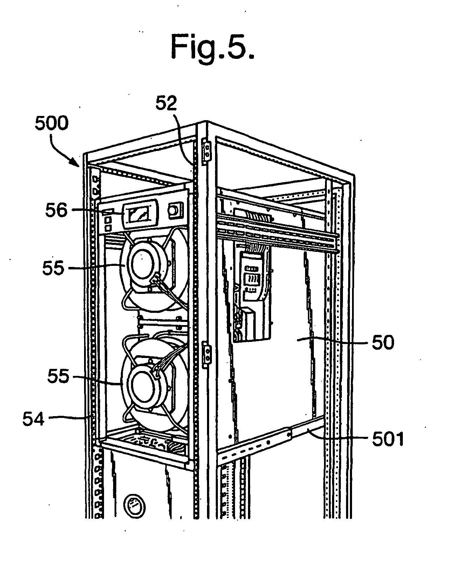

Fig. 5 shows a cooling unit 50 mounted within a 19" rack 500. The cooling unit 50 is positioned on mounting base 501 and attached to the rails 52, 54 by mounting brackets. The unit 50 is dimensioned to fit within the rack 500 such that this unit can easily be inserted into existing datacentres. Fans 55 are located at the front of the rack to increase ease of maintenance. A control panel 56 is also positioned at the front of the rack to allow the cooling unit.settings to be easily adjusted.

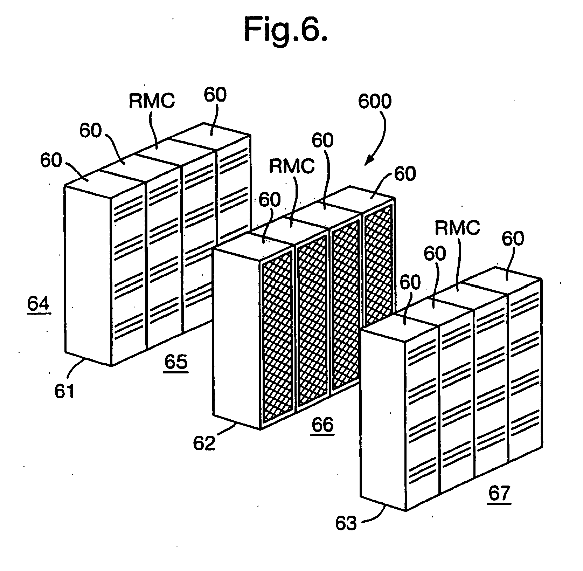

Fig. 6 shows a proposed layout for use in a data centre 600. Standard EIA 310 D racks 100 containing one or more cooling units 40 are referred to as rack mounted cooling units (RMC). These are positioned amongst racks 100 carrying servers, referred to as server racks 60. From the outside, the cooling units RMC and the server units 60 look identical. These is because the racks are panelled to form cabinets and the servers and cooling units are completely contained within these cabinets.

The server racks 60 are positioned in three rows 61, 62, 63 and the servers within rows 61 and 62 are arranged such that the hot air expelled from the servers is released into the aisle between these rows. This aisle 65 is known as a "hot" aisle and can be enclosed by panelling to prevent the hot air from dispersing throughout the remainder of the server room 600.

The rack mounted cooling units RMC within rows 61, 62 are arranged to draw in hot air from the hot aisle 65, cool this via heat transfer with cooling coil 41, and expel the cooled air into cold isles 64, 66. Row 63 comprises servers arranged to expel hot air into aisle 67 while the rack mounted cooling unit RMC within this row 63 is arranged to draw in hot air from this aisle 67 and expel this into cool aisle 66. In certain embodiments the rack mounted cooling units RMC can comprise a plenum (not shown) for attachment to one or more server racks 60 when the racks are in a single row configuration.

The use of rack mounted cooling units RMC in the present invention enables heat generated within servers to be removed at the source, rather than through general climate control of the entire data centre 600. By having a plurality of rack mounted cooling units RMC situated within rows 61, 62, 63, effective cooling can still be delivered in the event of failure of one or more or these units.

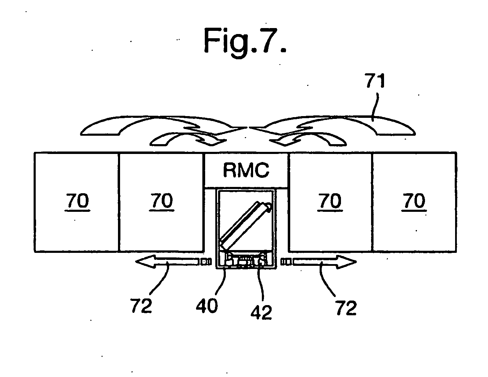

Although the housing 45 of the cooling unit 40 is designed to fit entirely within rack 100, it is also possible for the cooling unit 40 to be mounted such that the cooling unit partially extends out of the rack 100, such that the fan 42 is not located within the rack boundary, defined by framework 15. This enables the fan 42 to operate more efficiently and thus reduces the electrical power required for the fan motors of the cooling unit 40. This is shown schematically in Fig. 7.

Fig. 7 shows a row of server racks 70, all arranged so that hot air 71 is expelled into the same aisle. The row also comprise a rack mounted cooling unit RMC, in which a cooling unit 40 is located. The cooling unit 40 is positioned within the rack mounted cooling unit RMC such that the fan 42 protrudes from the rack boundary. When the fans are positioned outboard of the front of the rack in which the RMC is installed, any existing rack door is removed and a new facia is used to provide safety from rotating fans. As well as reducing the power consumption of the fan 42, this allows a stream of cool air 72 to be blown directly across the intake sides of server racks 70.

Although not shown in the above described embodiments, it is also possible for a rack 100 to contain a power distribution unit (PDU) and an uninterruptible power supply unit (UPS) as well as cooling unit 40. By supplying the PDU and UPS in appropriately sized housing these can be mounted to the rack 100 in a similar manner to the cooling unit 40, thus providing a number of essential data centre components within a single rack.

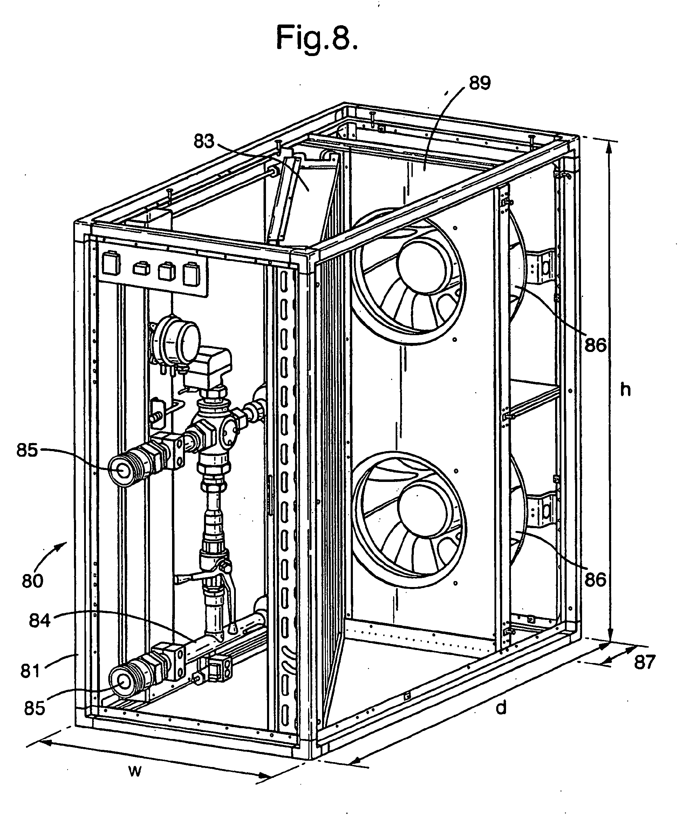

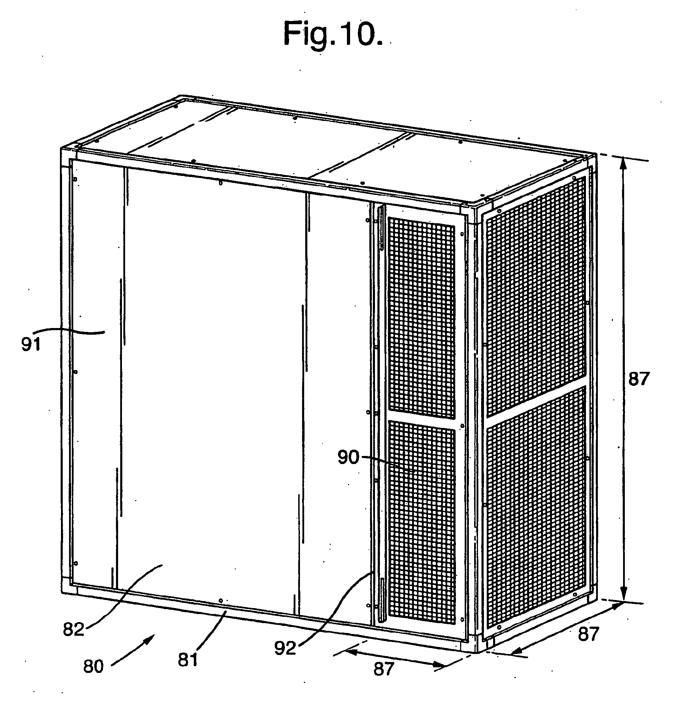

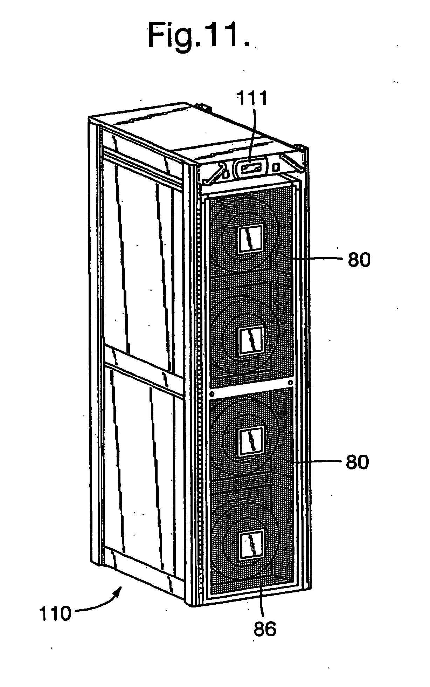

Figs. 8 and 11 illustrate a preferred cooling unit 80 in more detail. The cooling unit 80 comprises a frame 81 for supporting housing panels 82 (see Fig. 10). The frame 81 and housing panels 82 define a rectangular prism shape having a width w, depth d and height h. The height h is 20U (889 mm) and the width w and depth d are set to fit within a 19" ETA 310 rack, for example, a width w of 448 mm and depth d of 895 mm.

In Fig. 8, the rear of cooling unit 80 is shown. A planar cooling coil matrix 83 of height 20U is arranged vertically within the frame 81, extending along the diagonal of a smaller rectangular prism-shaped void at the back of the cooling unit 80. Pipes 84 with quick-coupling connectors 85 are provided for directing a supply of chilled water through the cooling coil matrix 83. A pair of electronically commutated, direct current motor, fans 86 are provided in a front region 87 of the frame 81, mounted one above the other and arranged to draw air through holes 88 in a manifold 89. The fans 86 direct the air outwardly, in a radial direction, from the sides of the housing 82.

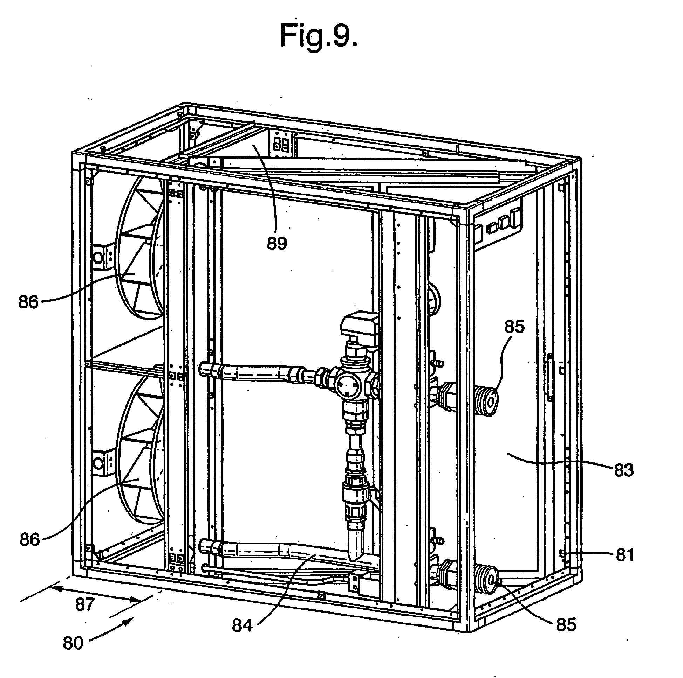

Fig. 9 shows a view of the cooling unit 80 from the side (with the housing panels 82 removed). Here it can be seen how the cooling coil matrix 83 extends from the corner adjacent the front region 87 to a rear corner of the frame 81, and extends the full height of the frame 81.

Fig. 10 illustrates a perspective view of the cooling unit 80 with the housing panels 82 in place. In the front region 87 of the housing 82, grilles 90 are provided in the side panels 91. When the cooling unit 80 is arranged in a rack with the fans 86 located outside the rack boundary, air can escape through the grilles 90 in the side panels 91 that surround the front region 87. An outwardly projecting, vertically extending flange 92 may be provided at the rear edge of the grille 90. When the cooling unit 80 is in a semi-recessed configuration, the flange 92 can abut against the vertical U-rail of the rack to provide extra stability. If it is desired to mount the cooling unit 80 in a recessed configuration, then the grille 90, which is in the form of a removable panel, can be replaced with a closed off panel (not shown), and in that way provide continuous closed off sides for the housing 82.

The fans 86 require around 20% less power in this semi-recessed configuration to move the same amount of air as in a recessed configuration (or with the grilles closed off). Despite the advantages of the semi-recessed configuration, the installer may still prefer to mount the cooling unit 80 in the rack in a recessed configuration, where the fans 86 are pulled back to within the rack boundary, for example, to maintain the neat straight lines of the aisle surfaces. In this configuration the grilles 90 may be closed off by adjacent equipment or with separate panels.

Fig. 11 illustrates a perspective view of a double cooling unit 110 consisting of two cooling units 80, each of a height 20U and each containing two fans 86 and one cooling coil matrix 83 (not visible). The cooling units 80 are stacked one on tope of the other. A controller unit 111 of height 2U is provided at the top of the stack for controlling the operation of the pair of cooling units 80.

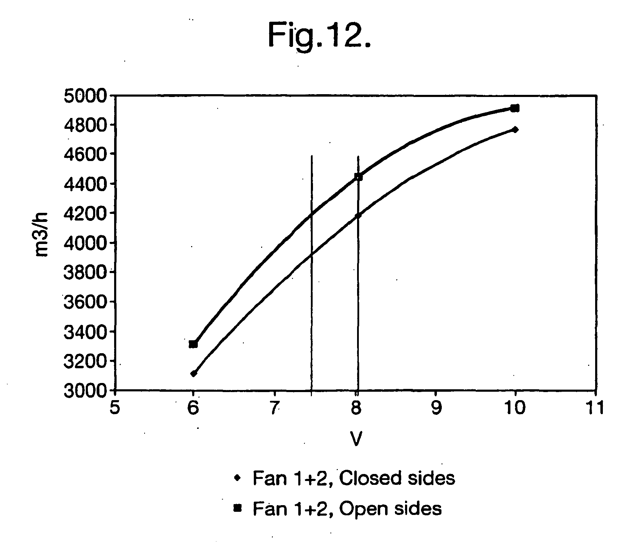

Fig. 12 shows the benefits that can be obtained through mounting the cooling units 80 such that the fans 86 are located outside of the rack boundary (i.e. protruding into the rack aisle), in order to permit air to be directed sideways, across the front of the remainder of the rack. The graph shows the volume of air that can be moved by the fans operating at particular signal voltages. The lower curve is for the fans when the sides are closed, for example, as with a recessed configuration. The upper curve is for when the sides are open, and much higher airflow volumes are observed.

For example with the signal voltage set to 8V, with closed sides an airflow of 4170 $m^3$/h was obtained, whereas with the sides open, an airflow of 4439 $m^3$/h was measured. This is an increase of 6.5%. To put this another way, in order to produce the same airflow volume as a recessed configuration, the semi-recessed configuration can be run at a signal voltage of around 10% less, reducing the power consumption significantly.

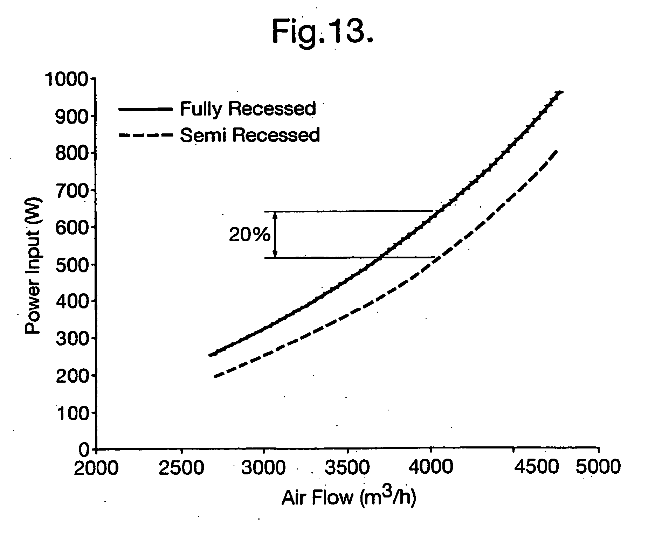

Fig. 13 shows graphically the power savings which can be achieved by moving the cooling unit from a recessed configuration to a semi-recessed configuration across the normal operating range of air volumes. At air flows of 4000 $m^3$/h, a 20% power input reduction is obtained by pulling the cooling unit forward in its rack so that it protrudes beyond the rack boundary in its semi-recessed configuration.

Table 1 illustrates the effect of opening or closing off the panels adjacent the fans, i.e., shows the effect of a semi-recessed or recessed configuration. The variation in the power consumed by the fans and the observed airflow volume is shown as a function of the operating signal voltage of the fans. Table 1 also shows the difference in the power usage between the closed and open panel arrangements for each of the signal voltages and the percentage power reduction obtained by moving the recessed cooling unit into a semi recessed configuration.

As can be seen, the power usage varies according to the signal voltage used and the speed of the fan. Generally signal voltages of 5V or more would be used for most applications. In this region of operation, power savings of 15 to 25% can be achieved and higher airflow volumes are achieved. It can also be seen how the same airflow volume of a closed panel arrangement can be obtained in an open panel arrangement operating at lower DC signal voltages, again resulting in energy savings.

The operating noise of the fan running at a lower speed will be less. In addition, the semi-recessed configuration allows the cooling unit to be pulled forward, creating a larger void at the rear to provide a plenum for feeding hot air into the cooling unit If desired, grilles or punched out regions can be provided in the side of the housing to feed hot air directly from the back of an adjacent server unit.

In summary therefore the cooling unit and the racks of the present invention comprising this cooling unit, allow the benefits of close coupled cooling to be obtained without the expense and disruption caused by the use of integral, stand-alone units. Instead, the cooling unit used in the present invention can quickly and simply be mounted into any standard EIA 310 D rack of the type found in all data centres and computer server rooms. The cooling unit may, for example, be provided as a stand alone 20U unit, or in other arrangements where high density cooling is required may be provided as two 20U units stacked one above the other or more preferably as a four fan 40U unit.

Thus, at least in the preferred embodiments, the present invention can be seen to provide: a cooling unit of a flexible design that can be used in any conventional IT rack; it is non-invasive and can be installed with the minimum of disruption; it can be used with hot or cold aisle enclosures; units can be added when, where and as needed; it provides easy service access with non-proprietary components; allows high density in any rack; requires a lower water side pressure drop; uses electronically commutated fan motors; provides row level redundancy; and allows an energy efficient semi-recessed configuration.

It will be appreciated that the embodiments described above are preferred embodiments only of the invention. Thus various changes could be made to the embodiments shown which would fall within the scope of the invention as defined by the claims. For example, the cooling units could be shaped to fit within an alternative rack configuration.

Table 1

| Signal Voltage/V | CLOSED PANELS | | OPEN PANELS | | POWER REDUCTION | |
|---|---|---|---|---|---|---|
| | Airflow/ m³/h | Power Consumed/W | Airflow/ m³/h | Power Consumed/W | Difference in Power Consumed/W | Percentage Reduction |
| 0.1 | 0 | 0 | 0 | 0 | 0 | |
| 0.2 | 61 | 1 | 68 | 0 | 0 | 57% |
| 0.3 | 121 | 2 | 136 | 1 | 1 | 52% |
| 0.4 | 181 | 3 | 203 | 2 | 1 | 47% |
| 0.5 | 241 | 5 | 270 | 3 | 3 | 64% |
| 0.6 | 301 | 6 | 336 | 4 | 4 | 58% |
| 0.7 | 361 | 8 | 402 | 5 | 4 | 54% |
| 0.8 | 420 | 10 | 468 | 6 | 5 | 50% |
| 0.9 | 479 | 12 | 534 | 8 | 6 | 47% |
| 1 | 538 | 14 | 599 | 10 | 6 | 44% |
| 1.1 | 596 | 17 | 663 | 12 | 7 | 42% |
| 1.2 | 654 | 19 | 728 | 14 | 8 | 40% |
| 1.3 | 712 | 22 | 792 | 16 | 8 | 38% |
| 1.4 | 770 | 25 | 855 | 19 | 9 | 36% |
| 1.5 | 827 | 28 | 919 | 21 | 12 | 43% |
| 1.6 | 885 | 32 | 981 | 24 | 13 | 41% |
| 1.7 | 942 | 35 | 1044 | 27 | 14 | 40% |
| 1.8 | 998 | 39 | 1106 | 30 | 15 | 38% |
| 1.9 | 1055 | 43 | 1168 | 34 | 16 | 37% |
| 2 | 1111 | 47 | 1229 | 37 | 17 | 35% |
| 2.1 | 1167 | 51 | 1290 | 41 | 18 | 34% |
| 2.2 | 1223 | 56 | 1351 | 45 | 19 | 33% |
| 2.3 | 1278 | 61 | 1411 | 49 | 19 | 32% |
| 2.4 | 1333 | 65 | 1471 | 53 | 20 | 31% |
| 2.5 | 1388 | 70 | 1531 | 58 | 21 | 30% |
| 2.6 | 1443 | 76 | 1590 | 63 | 22 | 29% |
| 2.7 | 1497 | 81 | 1649 | 67 | 23 | 28% |
| 2.8 | 1552 | 86 | 1707 | 72 | 29 | 33% |
| 2.9 | 1606 | 92 | 1765 | 77 | 30 | 32% |
| 3 | 1659 | 98 | 1823 | 83 | 31 | 31% |
| 3.1 | 1713 | 104 | 1881 | 88 | 32 | 31% |
| 3.2 | 1766 | 110 | 1938 | 94 | 33 | 30% |
| 3.3 | 1819 | 117 | 1994 | 100 | 34 | 29% |
| 3.4 | 1872 | 123 | 2051 | 106 | 35 | 28% |
| 3.5 | 1924 | 130 | 2107 | 112 | 36 | 28% |
| 3.6 | 1976 | 137 | 2162 | 119 | 37 | 27% |
| 3.7 | 2028 | 144 | 2217 | 125 | 39 | 27% |
| 3.8 | 2080 | 152 | 2272 | 132 | 40 | 26% |
| 3.9 | 2131 | 159 | 2327 | 139 | 41 | 26% |
| 4 | 2182 | 167 | 2381 | 146 | 48 | 29% |
| 4.1 | 2233 | 175 | 2434 | 153 | 50 | 28% |
| 4.2 | 2284 | 183 | 2488 | 161 | 51 | 28% |
| 4.3 | 2334 | 191 | 2541 | 168 | 52 | 27% |
| 4.4 | 2385 | 200 | 2593 | 176 | 54 | 27% |
| 4.5 | 2435 | 208 | 2646 | 184 | 55 | 26% |
| 4.6 | 2484 | 217 | 2698 | 192 | 56 | 26% |

(continued)

| Signal Voltage/V | CLOSED PANELS | | OPEN PANELS | | POWER REDUCTION | |
|---|---|---|---|---|---|---|
| | Airflow/ m³/h | Power Consumed/W | Airflow/ m³/h | Power Consumed/W | Difference in Power Consumed/W | Percentage Reduction |
| 4.7 | 2534 | 226 | 2749 | 201 | 58 | 25% |
| 4.8 | 2583 | 235 | 2800 | 209 | 59 | 25% |
| 4.9 | 2632 | 244 | 2851 | 218 | 60 | 25% |
| 5 | 2680 | 254 | 2902 | 227 | 62 | 24% |
| 5.1 | 2729 | 264 | 2952 | 236 | 63 | 24% |
| 5.2 | 2777 | 273 | 3001 | 245 | 73 | 27% |
| 5.3 | 2825 | 283 | 3051 | 254 | 74 | 26% |
| 5.4 | 2873 | 294 | 3100 | 264 | 76 | 26% |
| 5.5 | 2920 | 304 | 3148 | 274 | 77 | 25% |
| 5.6 | 2967 | 315 | 3197 | 284 | 79 | 25% |
| 5.7 | 3014 | 325 | 3245 | 294 | 80 | 25% |
| 5.8 | 3061 | 336 | 3292 | 304 | 82 | 24% |
| 5.9 | 3107 | 347 | 3339 | 315 | 83 | 24% |
| 6 | 3153 | 359 | 3386 | 325 | 85 | 24% |
| 6.1 | 3199 | 370 | 3432 | 336 | 86 | 23% |
| 6.2 | 3245 | 382 | 3479 | 347 | 88 | 23% |
| 6.3 | 3290 | 394 | 3524 | 358 | 89 | 23% |
| 6.4 | 3335 | 406 | 3570 | 370 | 91 | 22% |
| 6.5 | 3380 | 418 | 3615 | 381 | 92 | 22% |
| 6.6 | 3425 | 430 | 3659 | 393 | 94 | 22% |
| 6.7 | 3469 | 443 | 3703 | 405 | 96 | 22% |
| 6.8 | 3513 | 455 | 3747 | 417 | 97 | 21% |
| 6.9 | 3557 | 468 | 3791 | 429 | 99 | 21% |
| 7 | 3601 | 481 | 3834 | 442 | 100 | 21% |
| 7.1 | 3644 | 495 | 3877 | 454 | 102 | 21% |
| 7.2 | 3687 | 508 | 3919 | 467 | 103 | 20% |
| 7.3 | 3730 | 522 | 3961 | 480 | 105 | 20% |
| 7.4 | 3773 | 536 | 4003 | 493 | 106 | 20% |
| 7.5 | 3815 | 550 | 4044 | 506 | 108 | 20% |
| 7.6 | 3857 | 564 | 4085 | 520 | 109 | 19% |
| 7.7 | 3899 | 578 | 4126 | 534 | 111 | 19% |
| 7.8 | 3941 | 593 | 4166 | 548 | 113 | 19% |
| 7.9 | 3982 | 607 | 4206 | 562 | 114 | 19% |
| 8 | 4023 | 622 | 4245 | 576 | 116 | 19% |
| 8.1 | 4064 | 637 | 4284 | 590 | 117 | 18% |
| 8.2 | 4105 | 653 | 4323 | 605 | 119 | 18% |
| 8.3 | 4145 | 668 | 4362 | 619 | 120 | 18% |
| 8.4 | 4185 | 684 | 4400 | 634 | 122 | 18% |
| 8.5 | 4225 | 699 | 4437 | 649 | 124 | 18% |
| 8.6 | 4265 | 715 | 4475 | 665 | 125 | 18% |
| 8.7 | 4304 | 731 | 4512 | 680 | 127 | 17% |
| 8.8 | 4343 | 748 | 4548 | 696 | 128 | 17% |
| 8.9 | 4382 | 764 | 4584 | 712 | 130 | 17% |
| 9 | 4421 | 781 | 4620 | 728 | 132 | 17% |
| 9.1 | 4459 | 798 | 4656 | 744 | 133 | 17% |
| 9.2 | 4497 | 815 | 4691 | 760 | 135 | 17% |

(continued)

| Signal Voltage/V | CLOSED PANELS | | OPEN PANELS | | POWER REDUCTION | |
|---|---|---|---|---|---|---|
| | Airflow/ m³/h | Power Consumed/W | Airflow/ m³/h | Power Consumed/W | Difference in Power Consumed/W | Percentage Reduction |
| 9.3 | 4535 | 832 | 4725 | 776 | 136 | 16% |
| 9.4 | 4573 | 850 | 4760 | 793 | 138 | 16% |
| 9.5 | 4610 | 867 | 4794 | 810 | 140 | 16% |
| 9.6 | 4647 | 885 | 4828 | 827 | 141 | 16% |
| 9.7 | 4684 | 903 | 4861 | 844 | 143 | 16% |
| 9.8 | 4721 | 921 | 4894 | 862 | 144 | 16% |
| 9.9 | 4757 | 939 | 4926 | 879 | 146 | 16% |
| 10 | 4793 | 958 | 4958 | 897 | 148 | 15% |

**Claims**

1. An IT server rack containing a cooling unit (40; 50; 80), the cooling unit comprising
   at least one cooling coil (41; 83),
   at least one fan (42; 55; 86) for circulating air through said at least one cooling coil, and
   a housing (45; 82) of a rectangular prismatic shape that contains said at least one cooling coil and fan, said at least one fan being provided in a front region (87) of the housing and said at least one cooling coil being provided in a rear region of the housing,
   **characterised in that** said housing (45; 82) is sized to fit within the IT server rack (100; 500) and is arranged for attachment to said rack, wherein the cooling unit is adapted to be mounted in a semi-recessed configuration where the at least one fan (42; 55) is located projecting beyond the rack boundary creating a larger void at the rear between two adjacent server racks to provide a plenum for feeding hot air into the cooling unit, both vertical sides (91) of the cooling unit being provided with a grille (90) in the front region of the housing adjacent the at least one fan to allow air to exit from both sides of the housing when the at least one fan is located projecting beyond the rack boundary, while said rear region of the housing is provided with closed sides enclosing the at least one cooling unit.

2. A rack as claimed in claim 1, wherein said rack further comprises a return air plenum attached to the rack or the cooling unit, said plenum being extendible so as to enclose the rear of at least one standard EIA 310D rack.

3. A rack as claimed in claim 2, wherein the plenum encloses more than one EIA 310 D rack.

4. A rack as claimed in claim 2 or 3, wherein the plenum further comprises a liner or panel positioned at the rear of the rack containing the cooling unit and additional liners or panels similarly positioned on one or more adjacent server racks to create a sealed plenum directing emitted hot air to the cooling unit (40; 50; 80).

5. A rack as claimed in claim 1, wherein grilles or punched out regions are provided in the side of the rack's housing to feed hot air directly from the back of an adjacent server unit.

6. A rack as claimed in any preceding claim, wherein each grille (90) in the front region of the housing is provided as a removable grille panel.

7. A rack as claimed in claim 6, wherein the grille panel includes an outwardly projecting, vertically extending flange (92) for abutment against a vertical U rail of the rack when the cooling unit (40; 50; 80) is in the semi-recessed configuration.

8. A rack as claimed in any preceding claim, wherein the housing comprises mounting brackets for attachment to said rack (100; 500).

9. A rack as claimed in claim 8, wherein the mounting brackets are arranged to provide indirect attachment to said rack (100; 500).

**10.** A rack as claimed in claim 8 or 9, wherein the mounting brackets are arranged to provide two or more mounting positions to mount the cooling unit in a recessed configuration where the at least one fan (42; 55; 86) is located within the rack boundary, and a semi-recessed configuration where the at least one fan is located outside the rack boundary.

**11.** A rack as claimed in any preceding claim, wherein the housing of the cooling unit (40; 50; 80) is sized to fit within an IT server rack conforming to EIA 310 D specifications.

**12.** A rack as claimed in claim 11, wherein the housing has a width of approximately 448 millimetres, a depth of approximately 895 millimetres and a height of approximately 890 millimetres or 1778 millimetres.

**13.** A rack as claimed in any preceding claim, wherein the housing of the cooling unit (40; 50; 80) contains two fans (42; 55; 86) and a single cooling coil (41; 83).

**14.** A rack as claimed in any of claims 1 to 12, wherein the housing of the cooling unit contains four fans (86) and a single cooling coil (41; 83).

**15.** A rack as claimed in claim 13 or 14, further containing a self-contained, removable power distribution unit and a self-contained, removable uninterruptible power supply unit.

**16.** A data centre comprising a plurality of racks as claimed in any of claims 1 to 15, wherein the racks each contain one or more cooling units (40; 50; 80) and the cooling units are mounted in the racks in a semi-recessed configuration with the fans (42; 55; 86) projecting beyond the rack boundaries to provide close coupled cooling through supplying a cooled air stream directly across the front of the adjacent racks housing the IT servers.

**17.** A data centre as claimed in claim 16, wherein the number of cooling units (40; 50; 86) provided in the racks gives a level of redundancy of +1 or +2.

**Patentansprüche**

**1.** IT-Server-Rack, das eine Kühleinheit (40; 50; 80) enthält, wobei die Kühleinheit umfasst
wenigstens eine Kühlschlange (41; 83),
wenigstens ein Gebläse (42; 55; 86), um Luft durch die wenigstens eine Kühlschlange zirkulieren zu lassen, und ein Gehäuse (45; 82) in einer rechteckigen prismatischen Form, das die wenigstens eine Kühlschlange und das Gebläse enthält, wobei wenigstens ein Gebläse in einem vorderen Bereich (87) des Gehäuses vorgesehen ist und die wenigstens eine Kühlschlage in einem hinteren Bereich des Gehäuses vorgesehen ist,
**dadurch gekennzeichnet, dass** das Gehäuse (45; 82) so bemessen ist, dass es in das IT-Server-Rack (100; 500) passt, und dazu ausgelegt ist, an dem Rack befestigt zu werden, wobei die Kühleinheit beschaffen ist, um in einer halbeingelassenen Konfiguration angebracht zu werden, wobei das wenigstens eine Gebläse (42; 45) über die Rack-Grenze hinaus vorstehend angeordnet ist, wobei bzw. wodurch ein größerer Hohlraum auf der Rückseite zwischen zwei benachbarten Server-Racks erzeugt wird, um eine Kammer zum Einspeisen heißer Luft in die Kühleinheit zu schaffen, wobei beide vertikalen Seiten (91) der Kühleinheit mit einem Grill (90) im vorderen Bereich des Gehäuses benachbart zu dem wenigstens einem Gebläse versehen sind, um der Luft zu erlauben, aus beiden Seiten des Gehäuses auszutreten, wenn das wenigstens eine Gebläse über die Rack-Grenze hinaus vorstehend angeordnet ist, während der hintere Bereich des Gehäuses mit verschlossenen Seiten versehen ist, die die wenigstens eine Kühleinheit umschließen.

**2.** Rack nach Anspruch 1, wobei das Rack ferner eine Rückluftkammer umfasst, die an dem Rack oder der Kühleinheit befestigt ist, wobei die Kammer ausdehnbar ist, um die Rückseite wenigstens eines Standard-EIA-310D-Racks zu umschließen.

**3.** Rack nach Anspruch 2, wobei die Kammer mehr als ein EIA-310-D-Rack umschließt.

**4.** Rack nach Anspruch 2 oder 3, wobei die Kammer ferner eine Auskleidung oder eine Platte, die an der Rückseite des Racks positioniert ist, das die Kühleinheit enthält, und zusätzlichen Auskleidungen oder Platten, die ähnlich an einem oder mehreren benachbarten Server-Racks positioniert sind, umfasst, um eine abgedichtete Kammer zu erzeugen, die die emittierte heiße Luft zur Kühleinheit (40; 50; 80) lenkt.

**5.** Rack nach Anspruch 1, wobei die Grills oder ausgestanzten Bereiche in der Seite des Gehäuses des Racks vorgesehen sind, um heiße Luft direkt von der Rückseite einer benachbarten Server-Einheit einzuspeisen.

**6.** Rack nach einem vorhergehenden Anspruch, wobei jeder Grill (90) im vorderen Bereich des Gehäuses als eine entfernbare Grillplatte vorgesehen ist.

**7.** Rack nach Anspruch 6, wobei die Grillplatte einen nach außen vorstehenden, vertikal verlaufenden Flansch (92) für das Widerlager gegen eine vertikale U-Schiene des Racks enthält, wenn sich die Kühleinheit (40; 50; 80) in der halbeingelassenen Konfiguration befindet.

**8.** Rack nach einem vorhergehenden Anspruch, wobei das Gehäuse Montageträger für die Befestigung an dem Rack (100; 500) umfasst.

**9.** Rack nach Anspruch 8, wobei die Montageträger angeordnet sind, um eine indirekte Befestigung an dem Rack (100; 500) zu schaffen.

**10.** Rack nach Anspruch 8 oder 9, wobei die Montageträger angeordnet sind, um zwei oder mehr Montagepositionen zu schaffen, um die Kühleinheit in einer eingelassenen Konfiguration, in der sich das weinigstens eine Gebläse (42; 55; 86) innerhalb der Rack-Grenze befindet, und in einer halbeingelassenen Konfiguration, in der sich das wenigstens eine Gebläse außerhalb der Rack-Grenze befindet, zu montieren.

**11.** Rack nach einem vorhergehenden Anspruch, wobei das Gehäuse der Kühleinheit (40; 50; 80) ausgelegt ist, um in ein IT-Server-Rack zu passen, das den EIA 310 D-Spezifikationen entspricht.

**12.** Rack nach Anspruch 11, wobei das Gehäuse eine Breite von etwa 448 Millimetern, eine Tiefe von etwa 895 Millimetern und eine Höhe von etwa 890 Millimetern oder 1778 Millimetern besitzt.

**13.** Rack nach einem vorhergehenden Anspruch, wobei das Gehäuse der Kühleinheit (40; 50; 80) zwei Gebläse (42; 55; 86) und eine einzige Kühlschlange (41; 83) enthält.

**14.** Rack nach einem der Ansprüche 1 bis 12, wobei das Gehäuse der Kühleinheit vier Gebläse (86) und eine einzige Kühlschlange (41; 83) enthält.

**15.** Rack nach Anspruch 13 oder 14, das ferner eine selbstständige entfernbare Leistungsverteilungseinheit und eine selbstständige, entfernbare unterbrechungsfreie Leistungsversorgungseinheit enthält.

**16.** Datenzentrum, das mehrere Racks nach einem der Ansprüche 1 bis 15 enthält, wobei jedes Rack eine oder mehrere Kühleinheiten (40; 50; 80) enthält und die Kühleinheiten in den Racks in einer halbeingelassenen Konfiguration angebracht sind, wobei die Gebläse (42; 55; 86) über die Rack-Grenzen hinaus vorstehen, um eine eng gekoppelte Kühlung durch Zuführen eines gekühlten Luftstroms direkt über die Vorderseite der benachbarten Racks, die die IT-Server unterbringen, zu schaffen.

**17.** Datenzentrum nach Anspruch 16, wobei die Anzahl der Kühleinheiten (40; 50; 86), die in den Racks vorgesehen sind, ein Niveau der Redundanz von +1 oder +2 ergibt.

**Revendications**

**1.** Baie de serveur IT contenant une unité de refroidissement (40 ; 50 ; 80), l'unité de refroidissement comportant au moins un serpentin de refroidissement (41 ; 83),
au moins un ventilateur (42 ; 55 ; 86) pour faire circuler de l'air à travers ledit au moins un serpentin de refroidissement, et
un logement (45 ; 82) d'une forme prismatique rectangulaire qui contient au moins un serpentin de refroidissement et un ventilateur, ledit au moins un ventilateur étant agencé dans une région avant (87) du logement et ledit au moins un serpentin de refroidissement étant agencée dans une région arrière du logement,
**caractérisée en ce que** ledit logement (45 ; 82) est dimensionné de manière à tenir à l'intérieur d'une baie de serveur IT (100 ; 500) et est agencé de manière à être fixé à ladite baie, dans lequel l'unité de refroidissement est adaptée pour être montée dans une configuration semi enfoncée dans laquelle le au moins un ventilateur (42 ; 55) est positionné en saillie au-delà de la limite de la baie de manière à créer un vide plus grand à l'arrière entre deux baies de serveur adjacentes pour fournir un espace de répartition de l'air afin d'envoyer de l'air chaud dans l'unité de refroidissement, les deux côtés verticaux (91) de l'unité de refroidissement étant munis d'une grille (90) dans la région avant du logement adjacente au au moins un ventilateur pour permettre à l'air de s'échapper des deux côtés du logement lorsque le au moins un ventilateur est positionné en saillie au-delà de la limite de la baie, alors que ladite région arrière du logement est munie de côtés fermés entourant la au moins une unité de refroidissement.

**2.** Baie selon la revendication 1, dans laquelle ladite baie comporte en outre un espace de répartition d'air de retour fixé à la baie ou à l'unité de refroidissement, ledit espace de répartition d'air étant extensible de manière à entourer l'arrière d'au moins une baie conforme à la norme EIA 310D.

**3.** Baie selon la revendication 2, dans laquelle l'espace de répartition d'air entoure plus d'une baie conforme à la norme EIA 310 D.

**4.** Baie selon la revendication 2 ou 3, dans laquelle l'espace de répartition d'air comporte en outre un séparateur ou un panneau positionné à l'arrière de la baie contenant l'unité de refroidissement et des séparateurs ou des panneaux supplémentaires positionnés de manière similaire sur une ou plusieurs baies de serveur adjacentes afin de créer un espace de répartition d'air étanche dirigeant l'air chaud émis vers l'unité de refroidissement (40 ; 55 ; 80).

**5.** Baie selon la revendication 1, dans laquelle des grilles ou des régions perforées sont agencées dans un côté du logement de baie pour envoyer de l'air chaud directement depuis l'arrière d'une unité de serveur adjacente.

**6.** Baie selon l'une quelconque des revendications précédentes, dans laquelle chaque grille (90) dans la région avant du logement est agencée sous forme d'un panneau de grille amovible.

**7.** Baie selon la revendication 6, dans laquelle le panneau de grille inclut un rebord s'étendant verticalement, faisant saillie vers l'extérieur (92) pour venir en butée contre un rail en U vertical de la baie lorsque l'unité de refroidissement (40 ; 50 ; 80) est dans la configuration semi enfoncée.

**8.** Baie selon l'une quelconque des revendications précédentes, dans laquelle le logement comporte des supports de fixation pour une fixation à ladite baie (100 ; 500).

**9.** Baie selon revendication 8, dans laquelle les supports de fixation sout conçus pour fournir une fixation indirecte à ladite baie (100; 500).

**10.** Baie selon la revendication 8 ou 9, dans laquelle les supports de montage sont conçus pour fournir deux ou plus de deux oppositions de montage afin de monter l'unité de refroidissement dans une configuration enfoncée dans laquelle le au moins un ventilateur (42 ; 55 ; 86) est positionné dans la limite de la baie, et une configuration semi enfoncée dans laquelle le au moins un ventilateur est positionné à l'extérieur de la limite de la baie.

**11.** Baie selon l'une quelconque des revendications précédentes, dans laquelle le boîtier de l'unité de refroidissement (40 ; 55, 80) est dimensionné pour s'ajuster dans une baie de serveur IT conformément aux spécifications de la norme EIA 310 D.

**12.** Baie selon la revendication 11, dans laquelle le logement a une largeur d'environ 448 mm, une profondeur d'environ 895 mm et une hauteur d'environ 890 mm ou 1778 mm.

**13.** Baie selon l'une quelconque des revendications précédentes, dans laquelle le logement de l'unité de refroidissement (40 ; 50 ; 80) contient deux ventilateurs (42 ; 55 ; 86) et un serpentin de refroidissement unique (41 ; 83).

**14.** Baie selon l'une quelconque des revendications 1 à 12, dans laquelle le logement de l'unité de refroidissement contient quatre ventilateurs (86) et un serpentin de refroidissement unique (41 ; 83).

**15.** Baie selon la revendication 13 ou 14, comportant en outre une unité de distribution de puissance amovible, autonome et une unité d'alimentation sans coupure amovible, autonome.

**16.** Centre de données comportant une pluralité de baies comme revendiqué dans l'une quelconque des revendications 1 à 15, dans lequel chaque baie contient un une ou plusieurs unités de refroidissement (40 ; 50 ; 80) et les unités de refroidissement sont montées dans les baies dans une configuration semi-enfoncée avec les ventilateurs (42 ; 55 ; 86) faisant saillie au-delà des limites de la baie pour fournir un refroidissement étroitement couplé via l'alimentation d'un courant d'air refroidi directement à travers l'avant des baies adjacentes contenant les serveurs IT.

17. Centre de données comme revendiqué dans la revendication 16, dans lequel le nombre d'unités de refroidissement (40 ; 50 ; 86) agencées dans les baies donne un niveau de redondance de +1 ou +2.

# Fig.1.

# Fig.2.

# Fig.3A.

# Fig.3B.

# Fig.3C.

# Fig.4A.

# Fig.4B.

# Fig.4C.

# Fig.5.

# Fig.6.

# Fig.7.

71

RMC

70 70 70 70

72 40 42 72

# Fig.8.

# Fig.9.

# Fig.10.

# Fig.11.

# Fig.12.

- ◆ Fan 1+2, Closed sides
- ■ Fan 1+2, Open sides

# Fig.13.

**EP 2 298 051 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2006139877 A